# EUROPEAN PATENT APPLICATION

(11) **EP 4 400 816 A1**
(43) Date of publication of application: **17.07.2024**
(21) Application number: 23151597.4
(22) Date of filing: 13.01.2023
(51) Int. Cl.: G01H 1/00, G01H 3/00, H03M 1/06, H03M 1/12, G01H 11/06, G01M 13/028, H03H 11/12

(54) **HIGH-BANDWIDTH VIBRATION SENSOR**

(71) Applicant: Sensirion AG, 8712 Stäfa (CH)
(72) Inventor: Looser, Flurin, 8640 Rapperswil (CH); Mrcarica, Zeljko, 8049 Zurich (CH); Ryter, Roland, 8608 Bubikon (CH); Schalch, Thomas, 8820 Wädenswil (CH); Keitel, Robert Christian, 8050 Zurich (CH)
(74) Representative: E. Blum & Co. AG

(57) **Abstract**

The invention refers to a sensor arrangement (100) for sensing vibrations. The sensor arrangement (100) comprises a vibration sensor (10) configured to provide a sensor signal (101 and an amplifier unit (20) configured to amplify the sensor signal (101) over a predefined operation frequency band (61, 71) with a gain according to a first transfer function (60, 70) and to provide an analog amplifier output signal (102. The sensor arrangement further comprises an analog-to-digital converter, ADC, (30) configured to convert the amplifier output signal (102) into a first digital signal (103); and a digital compensation unit (40) configured to apply a second transfer function on the first digital signal (103), wherein the second transfer function is an inverse function of the first transfer function (60, 70). The operation frequency band (61, 71) comprises a low-frequency band (62, 72) and a high-frequency band (63, 73) and the gain of the predefined first transfer function (60, 70) is lower in the low-frequency band (62, 72) than in the high-frequency band (63, 73).

## Description

### Technical Field

The present invention relates to a vibration sensor arrangement, a system comprising a vibration sensor arrangement and a component, the use of a vibration sensor arrangement and a method for operating a vibration sensor arrangement.

### Background Art

Vibration sensors are widely used in many industrial applications.

Vibrations sensors that are suited for measurement of high-frequency vibrations, e.g. acoustic emission sensors, may face a problem as follows.

Vibrations (acoustic signals) have usually low amplitudes at high frequencies. This requires usage of a low noise input amplifier with high amplification. High amplification in this context means that the output signal of the amplifier is above the noise level of the analog-to-digital converter (ADC) used.

At the same time, vibration signals have typically high amplitudes at low frequencies. Using an amplifier with very high amplification may, however, lead to saturation of the ADC.

To circumvent this, available sensors with high bandwidth use a high-pass filter, thereby eliminating the low-frequency signal. This allows them to increase the amplification without the risk that high-amplitude low-frequency signals lead to saturation.

### Disclosure of the Invention

The problem to be solved by an aspect of the present invention is therefore to provide a vibration sensor arrangement that avoids one or more problems of the prior art, in particular to provide a vibration sensor with an increased bandwidth.

This problem is solved by a vibration sensor arrangement according to claim 1.

Hence according to embodiments of an aspect of the invention a sensor arrangement for sensing vibrations is provided. The sensor arrangement comprises a vibration sensor configured to provide a sensor signal and an amplifier unit configured to amplify the sensor signal over a predefined operation frequency band with a gain according to a first transfer function and to provide an analog amplifier output signal. The sensor arrangement further comprises an analog-to-digital converter, ADC, configured to convert the amplifier output signal into a first digital signal and a digital compensation unit configured to apply a second transfer function on the first digital signal, wherein the second transfer function is an inverse function of the first transfer function. The operation frequency band comprises a low-frequency band and a high-frequency band. The gain of the predefined first transfer function is lower in the low-frequency band than in the high-frequency band.

Such a method may provide several advantages. It is based on an insight of the inventors that the knowledge about the signal dynamic range of the vibration signals may be used to enhance the bandwidth of the vibration measurements. More particularly, the sensor arrangement comprises an amplifier unit which amplifies the sensor signal provided by the vibration sensors with a predefined gain over frequency. This gain may be particularly adapted for the respective vibration signal of the respective application. The gain over frequency is defined by a first transfer function. By applying the predefined first transfer function on the sensor signals the amplifier applies different analog amplification factors for different frequency ranges. More particularly, the analog amplifier has a lower gain in the low-frequency band and a higher gain in the high-frequency band of the operation frequency band.

Hence according to embodiments of the invention the sensor arrangement may use the sensor signal over the whole operation frequency band and there is no loss of signals due to filtering. More particularly, the low-frequency signal in the low-frequency band is amplified with a lower gain, but not eliminated. Hence a disadvantage of known approaches which cut out the low frequencies by a high-pass filter is overcome.

The first digital signal at the output of the ADC may be distorted in amplitude and phase. The digital compensation unit having the second transfer function works as inverse filter and allows to reconstruct the low-frequency signals in the digital domain.

In other words, the digital compensation unit has an inverse transfer function compared to the one that is implemented in the analog stage. By amplifying the low-frequency signals and correcting the phase-shift of the analog amplifier unit, the signal at the digital output of the digital compensation unit is neither distorted in the amplitude nor in the phase and comprises a digital representation of the vibration signal over the complete operation frequency band including the low-frequency band. This result in an advanced sensor operation.

Another advantage of embodiments of the invention is that such a method reduces the dynamic range of the analog amplifier output signal at the input of the ADC. And such a reduction of the dynamic range may allow the use of ADCs with a lower bit-resolution which in return may lead to a very cost efficient sensor arrangement.

According to such an approach the signal-to-noise ratio (SNR) may be maximized for each frequency and correspondingly the performance of the sensor arrangement can be optimized.

Embodiments of the invention may allow to use the internal ADC from a microcontroller. This is a very cost efficient solution which may in addition reduce the size of the sensor arrangement.

Furthermore, embodiments of the invention may facilitate the provision of sensor arrangements for applications having bandwidth and resolution requirements which are higher than offered by any available ADC or by any ADC with a reasonable price for the respective application.

According to an embodiment, the gain of the first transfer function increases over frequency until a predefined peak point, wherein the predefined peak point is in the high-frequency band. Investigations of the inventors have shown that such a first transfer function is particularly advantageous for the measurement of vibration signals.

The vibration sensor may be generally embodied as any sensor which can transform mechanical vibrations signals into electrical signals. According to embodiments, sensors with a broad bandwidth are particularly suited. According to an embodiment, the vibration sensor may be a piezoelectric sensor, in particular a piezoelectric strain sensor or a piezoelectric acceleration sensor. According to further embodiments, the vibration sensor may be a Micro-Electro-Mechanical System (MEMS) acceleration sensor or a microphone.

According to an embodiment, the sensor arrangement is particularly suited for broadband applications. According to embodiments, the operation frequency band has a bandwidth of more than 10 KHz, in particular more than 20 KHz.

According to an embodiment, the operation frequency band has a lower limit in a range between 0.1 Hz and 10 Hz and an upper limit between 10 kHz and 1 MHz.

Investigations of the inventors have shown that such an operation frequency band is particularly advantageous for the measurement of vibration signals.

According to an embodiment, the amplifier unit is embodied as a charge amplifier.

According to embodiments, the gain of the first transfer function of such a charge amplifier increases over frequency with a minimum value between 10⁻⁵ V/pC and 10⁻¹ V/pC and a maximum value between 10⁻¹ V/pC and 100 V/pC.

According to such an embodiment the first transfer function transfers a charge into a voltage.

However, according to other embodiments the first transfer function may also transfer a voltage into another voltage. While in case of a charge amplifier the amplifier unit receives a charge as sensor signal, according to other embodiments the amplifier unit may receive a voltage as sensor signal and hence operates as voltage amplifier.

According to embodiments, the operation frequency band comprises a medium-frequency band between the low-frequency band and the high-frequency band. The slope of the first transfer function is lower in the medium-frequency band than in the low-frequency band and at least in a first part of the high-frequency band, wherein the first part of the high-frequency band is adjacent to the medium-frequency band.

Investigations of the inventors have shown that such an operation frequency band is particularly advantageous for the measurement of vibration signals which have a dynamic range which is higher than the resolution of the given ADC. For such vibration signals the amplifier unit may be configured such by the first transfer function that in the medium frequency-band the quantization noise is higher than the noise of the amplifier output signal and hence small sensor signals may not be measured.

According to an embodiment of a further aspect of the invention, a system is provided which comprises a component configured to provide a vibration signal and a sensor arrangement for sensing the vibration signal of the component. The sensor arrangement comprises a vibration sensor which is configured to sense the vibration signal of the component and to provide a corresponding sensor signal being representative for the vibrations of the component. The sensor arrangement comprises an amplifier unit configured to amplify the sensor signal according to a first transfer function over a predefined operation frequency band and to provide an analog amplifier output signal. The sensor arrangement comprises an analog-to-digital converter, ADC, configured to convert the amplifier output signal into a first digital signal and a digital compensation unit configured to apply a second transfer function on the first digital signal. The second transfer function is an inverse function of the first transfer function. The vibration signal has higher amplitudes in a low-frequency band of the operation frequency band than in a high-frequency band of the operation frequency band and a higher noise level in the low-frequency band than in the high-frequency band. The amplifier unit is configured to provide an analog amplifier output signal having a noise level that is higher than a quantization noise level of the ADC at least in the low-frequency band and in the high-frequency band. According to embodiments, the amplifier unit is configured to provide an analog amplifier output signal having a noise level that is at least twice as high as the quantization noise level of the ADC at least in the low-frequency band and in the high-frequency band. According to embodiments, the amplifier unit is configured to provide an analog amplifier output signal having a noise level that is at least three times higher than the quantization noise level of the ADC at least in the low-frequency band and in the high-frequency band.

This facilitates the use of the respective ADC bit resolution in an advantageous manner, and in particular without imposing too high requirements on the analog amplifier unit. More particularly, such an approach allows to amplify high-frequency signals not more than required to optimize the signal-to-noise ratio.

For this reason, such an approach according to embodiments of the invention may be considered or denoted as "noise matching".

The use of such a "noise matching" approach may be in particular implemented by an amplifier unit which provides a gain of the predefined first transfer function which is lower in the low-frequency band than in the high-frequency band.

According to one embodiment, the amplifier unit is configured to provide an analog amplifier output signal having a noise level that is higher than the quantization noise level of the ADC over the whole operation frequency band.

According to another embodiment, the operation frequency band may comprise a medium-frequency band between the low-frequency band and the high-frequency band, wherein a slope of the first transfer function is lower in the medium-frequency band than in the low-frequency band and at least in a first part of the high-frequency band. According to such an embodiment, the amplifier unit may be configured to provide an analog amplifier output signal having a noise level that is higher than the quantization noise level of the ADC only in the low-frequency band and in the high-frequency band, while in the medium frequency band the analog amplifier output signal may have a noise level that is lower than the quantization noise level of the ADC.

Such an approach may be in particular used for systems comprising an ADC which has a lower resolution than the dynamic range of the vibration signal.

In the frequency bands, in particular the low-frequency band and the medium-frequency band, where the amplitudes of the vibration signal are high, the analog gain or in other words the analog amplification cannot be too high, so that the analog amplifier output signal does not saturate.

Investigations of the applicant have shown that in the low-frequency band the noise level of the vibration signals is typically high such that the noise level of the analog amplifier unit can still be kept above the quantization noise level of the ADC even with a lower gain. However, in the medium frequency band, the analog-amplifier unit is configured according to embodiments in such a way that the noise level of the analog amplifier output signal is lower or may be lower than the quantization noise level of the ADC.

And in the high-frequency band where the amplitude of the vibration signal is typically lower, the above mentioned noise matching approach is used, i.e. the analog amplifier unit amplifies the vibration signal in such a manner that the noise level of the analog amplifier output signal is higher than the quantization noise level of the ADC.

According to an embodiment, the medium-frequency band has a lower limit in a range between 5 Hz and 50 Hz and an upper limit between 200 Hz and 50 kHz, in particular an upper limit between 200 Hz and 1 kHz. Investigations of the applicant have shown that this is an advantageous range for the medium-frequency band.

According to embodiments, the component may be a machine, a tool, a production site, an infrastructure, an engine, a pump, a turbine, a bearing, a housing, a container, a building, a gear, a transportation means, a vehicle, a heater, a burner or a boiler.

Investigations of the applicant have shown that such components typically provide vibration signals for which the above explained noise-matching approach may be used in an advantageous manner. More particularly, the vibration signal of such components has typically higher amplitudes in the low-frequency band than in the high-frequency band and a higher noise level in the low-frequency band than in the high frequency-band.

According to embodiments of another aspect of the invention, a sensor arrangement as described above may be advantageously used for measuring vibrations of a component, preferably of a component of or a component coupled to one of a machine, a tool, a production site, an infrastructure, an engine, a pump, a turbine, a bearing, a housing, a container, a building, a gear, a transportation means and a vehicle.

According to further embodiments a sensor arrangement as described above may be advantageously used for monitoring a condition and / or a quality of a component, or the condition and / or a quality of a machine, a tool, a production site, infrastructure, an engine, a pump, a turbine, a bearing, a housing, a container, a building, a gear, a transportation means or a vehicle the component is comprised in or is coupled to.

According to further embodiments a sensor arrangement as described above may be advantageously used for predicting maintenance operations of a component or of a machine, a tool, a production site, infrastructure, an engine, a pump, a turbine, a bearing, a housing, a container, a building, a gear, a transportation means or a vehicle the component is comprised in or is coupled to.

According to further embodiments a sensor arrangement as described above may be advantageously used for measuring a status of one of a heater, a burner and a boiler, in particular measuring structure borne sound.

Investigations of the applicant have shown that such use cases typically involve the measuring or monitoring of vibration signals which have higher amplitudes in the low-frequency band than in the high-frequency band and a higher noise level in the low-frequency band than in the high frequency-band.

According to an embodiment of another aspect of the invention a method for operating a sensor arrangement according to the above mentioned aspect is provided.

The method comprises steps of receiving, by a vibration sensor, a vibration signal and providing, by the vibration sensor, a sensor signal. The method further comprises amplifying, by an amplifier unit, the sensor signal over a predefined operation frequency band with a gain according to a first transfer function, providing, by the amplifier unit, an analog amplifier output signal, converting, by an analog-to-digital converter, ADC, the amplifier output signal into a first digital signal and applying, by a digital compensation unit, a second transfer function on the first digital signal. The second transfer function is an inverse function of the first transfer function. The operation frequency band comprises a low-frequency band and a high-frequency band and the gain of the predefined first transfer function is lower in the low-frequency band than in the high-frequency band.

According to embodiments the vibration signal has higher amplitudes in the low-frequency band than in the high-frequency band and a higher noise level in the low-frequency band than in the high frequency-band.

According to embodiments, the analog amplifier output signal has a noise level that is higher than a quantization noise level of the ADC, in particular twice as high as the quantization noise level of the ADC, at least in the low-frequency band and in the high-frequency band.

According to embodiments, the analog amplifier output signal has a noise level that is higher than the quantization noise level of the ADC, in particular twice as high as the quantization noise level of the ADC, in the whole operation frequency band.

According to embodiments, the digital compensation unit provides a second digital signal as output signal, wherein the second digital signal provides a higher digital resolution of the vibration signal than the effective number of bits (ENOB) of the ADC.

This is a particular efficient usage of the ADC.

Features and advantages of one aspect of the invention may be applied to the other aspects of the invention as appropriate.

Other advantageous embodiments are listed in the dependent claims as well as in the description below.

### Brief Description of the Drawings

The invention will be better understood and objects other than those set forth above will become apparent from the following detailed description thereof. Such description makes reference to the annexed drawings, wherein:
Figure 1 shows a sensor arrangement for sensing vibrations according to an embodiment of the invention;
Figure 2 shows an embodiment of an amplifier unit;
Figure 3 shows an embodiment of a system comprising a component and a sensor arrangement for sensing vibrations of the component;
Figure 4 shows an embodiment of a diagram comprising a first transfer function of an amplifier unit according to an embodiment of the invention;
Figure 5 shows an embodiment of a diagram comprising another first transfer function of an amplifier unit according to an embodiment of the invention;
Figure 6 shows an arrangement comprising a more detailed implementation of a vibration sensor and an amplifier unit according to an embodiment of the invention;
Figure 7 shows a filter structure of a digital compensation unit according to an embodiment of the invention;
Figure 8 shows a filter structure of another digital compensation unit according to an embodiment of the invention;
Figure 9 shows an exemplary example of measurements of the frequency dependent dynamic range of a sensor arrangement according to an embodiment of the invention;
Figure 10 shows an exemplary example of measurements of the frequency dependent dynamic range of a sensor arrangement according to another embodiment of the invention;
Figure 11 shows an exemplary example of measurements of the noise spectral density of the overall analog noise and the quantization noise of a sensor arrangement according to an embodiment of the invention;
Figure 12 shows an exemplary example of measurements of the noise spectral density of the overall analog noise and the quantization noise of a sensor arrangement according to another embodiment of the invention; and
Figure 13 shows a flow chart of a method for operating a sensor arrangement according to an embodiment of the invention.

### Modes for Carrying Out the Invention

Same reference signs across the Figures refer to same elements.

At first, some general aspects and terms of embodiments of the invention will be introduced.

A charge amplifier is an electronic current integrator that generates a voltage which is proportional to the integrated value of the input current, or the total charge injected. Such a charge-amplifier operates as a charge-to-voltage converter and is particularly suited for the amplification of sensor signals derived from piezoelectric sensors.

A vibration sensor generally refers to a sensor which can transform mechanical vibration signals into electrical signals, in particular an electrical charge or an electrical voltage.

A transfer function may be generally referred to as a function which transfers or in other words converts an input signal into an output signal.

A first transfer function shall in particular denote the function of an amplifier unit which transfers, in particular amplifies, a sensor signal, in particular an input charge or input voltage, into an output voltage with a predefined gain over frequency.

A second transfer function may denote in particular the function of a digital compensation unit which establishes an inverse function of the first transfer function. The second transfer function shall in particular denote the function of the digital compensation unit which reconstructs in the digital domain the sensor signal of the operation frequency band from a first digital signal provided by an ADC which has converted the amplifier output signal into the digital domain.

A dynamic range of a sensor arrangement may be defined according to embodiments by the maximal RMS Value (Root Mean Square Value) of the vibration signal (frequency dependent) and the noise level of an electronic circuit that measures the vibration signal (also frequency dependent).

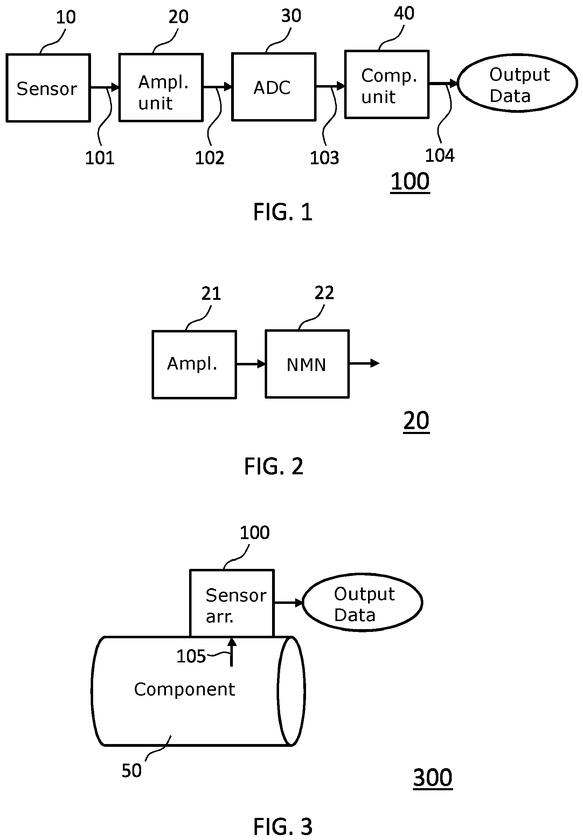

Figure 1 shows a sensor arrangement 100 for sensing vibrations. The sensor arrangement 100 comprises a vibration sensor 10 which is configured to sense mechanical vibrations and to provide a sensor signal 101. The sensor signal 101 is provided to an amplifier unit 20 which is configured to amplify the sensor signal 101 with a gain according to or in other words as defined by a first transfer function over a predefined operation frequency band. The amplifier unit 20 provides an analog amplifier output signal 102 to an analog-to-digital converter (ADC) 30. The ADC 30 is configured to convert the amplifier output signal into a first digital signal 103. The first digital signal 103 is provided to a digital compensation unit 40 which is configured to apply a second transfer function on the first digital signal 103. The second transfer function is in particular an inverse function of the first transfer function. The digital compensation unit 40 provides a second digital signal or output signal 104 comprising output data.

Figure 2 shows an embodiment of the amplifier unit 20 of Figure 1. The amplifier unit 20 encompasses an amplifier 21 and a noise matching network (NMN) 22. According to an embodiment the noise matching network 22 may be integrated into the amplifier 21. According to other embodiments, the noise matching network 22 may be implemented separately. The noise matching network 22 may be in particular configured to adapt the gain over frequency of the amplifier unit 20 and to implement thereby the first transfer function of the amplifier unit 20.

Figure 3 shows an embodiment of a system 300 comprising a component 50. The component 50 is configured to provide a vibration signal 105 to a sensor arrangement 100 for sensing the vibration signal of the component. The sensor arrangement 100 may be implemented as described with reference to Figure 1. The component 50 may be e.g. a machine, a tool, a production site, an infrastructure, an engine, a pump, a turbine, a bearing, a housing, a container, a building, a gear, a transportation means, a vehicle, a heater, a burner or a boiler.

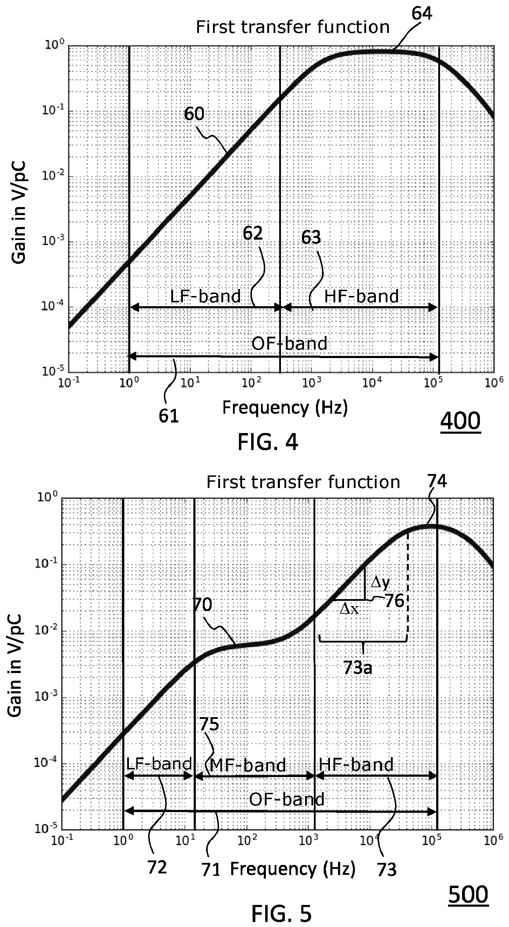

Figure 4 shows an embodiment of a diagram 400 comprising a first transfer function 60. The first transfer function 60 specifies a gain according to which the sensor signal 101 is amplified over a predefined operation frequency band 61. More particularly, the Y-axis of the diagram 400 shows the gain in V/pC of the amplifier unit 20 and the x-axis the frequency in Hz. According to this embodiment, the amplifier unit 20 is embodied as charge amplifier. The operation frequency band 61 comprises a low frequency band 62 and a high-frequency band 63. As can be seen in the diagram 400, the gain of the predefined first transfer function 60 increases with increasing frequency until a predefined peak or peak point 64. The predefined peak point 64 is in the high-frequency band 63. After having reached the predefined peak point 64, the gain may remain flat for a certain frequency range and may then decrease over frequency.

As shown in Figure 4, the respective gain of the first transfer function 60 is lower in the low-frequency band 62 than in the high-frequency band 63.

Figure 5 shows an embodiment of a diagram 500 comprising another first transfer function 70. The first transfer function 70 specifies a gain according to which the sensor signal 101 is amplified over a predefined operation frequency band 71. More particularly, the y-axis of the diagram 500 shows the gain in V/pC of the amplifier unit 20 and the x-axis the frequency in Hz. According to the embodiment the amplifier unit 20 is again embodied as charge amplifier. The operation frequency band 71 comprises a low frequency band 72 and a high-frequency band 73. Furthermore, the operation frequency band comprises a medium-frequency band 75 between the low-frequency band 72 and the high-frequency band 74. A slope Δy/Δx, 76, of the first transfer function 70 is lower in the medium-frequency band 75 than in the low-frequency band 72 and at least in a first part 73a of the high-frequency band 73. The first part 73a of the high-frequency band 73 is adjacent to the medium-frequency band 75.

As can be seen in diagram 500, the gain of the predefined first transfer function 70 increases with increasing frequency until a predefined peak or peak point 74. The predefined peak point 74 is in the high-frequency band 73. After having reached the predefined peak point 74, the gain may remain flat for a certain frequency range and may then decrease over frequency. As shown in figure 5, the respective gain of the first transfer function 70 is lower in the low-frequency band 72 than in the high-frequency band 73. Furthermore, the respective gain of the first transfer function 70 is lower in the medium-frequency band 75 than in the high-frequency band 73.

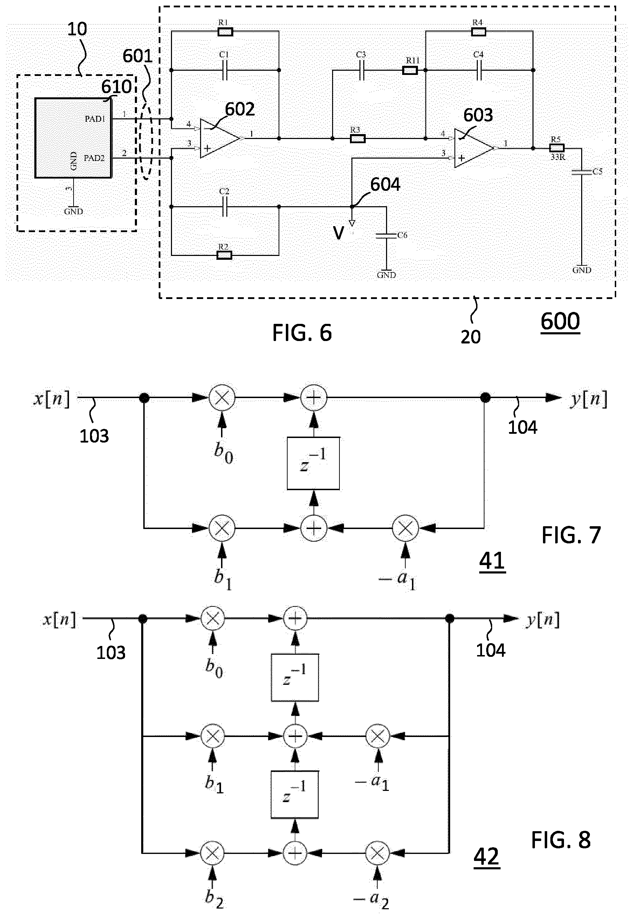

Figure 6 shows an arrangement 600 comprising a more detailed implementation of the vibration sensor 10 and the amplifier unit 20 of Figure 1.

The arrangement 600 comprises a sensor chip 610 as implementation of the sensor 10. The sensor chip 610 is coupled to ground and provides a differential sensor signal 601. The amplifier unit 20 is embodied as charge amplifier. It comprises two operational amplifiers 602 and 603 which are arranged in series. The differential sensor signal 601 is provided to the inverting and non-inverting input of the operational amplifier 602. The output signal of the operational amplifier 602 is provided via a resistor R3 to the inverting input of the operational amplifier 603. The output of the operational amplifier 602 is coupled via a parallel arrangement of a resistor R1 and a capacitor C1 to the inverting input. The output of the operational amplifier 603 is coupled via a feedback network comprising resistors R4, R11 and capacitors C3 and C4 to the output of the operational amplifier 602. The output of the operational amplifier 603 is coupled via a serial arrangement of a resistor R5 and a capacitor C5 to ground. The non-inverting input of the operational amplifier 603 is coupled via a network comprising a resistor R2 and a capacitor C2 to the non-inverting input of the operational amplifier 602. In addition, the non-inverting input of the operational amplifier 603 is coupled via a node 604 which is coupled to a voltage V and a capacitor C6 to ground.

By providing suitable values for the capacitors C1, C2, C3, C4 and C5 and the resistors R1, R11, R2, R3, R4 and R5, the gain over frequency of the amplifier unit 20 can be tuned over the operation frequency band. In particular, the wiring and values of the network comprising the capacitors C1, C2, C3, C4 and C5 and the resistors R1, R11, R2, R3, R4 and R5 establish an integrated noise matching network (NMN) which may be used to match or adapt the noise of the amplifier output signal to the quantization noise of the ADC 30. This will be explained in more detail further below.

Figure 7 shows a filter structure 41 as a possible implementation of the digital compensation unit 40 according to an embodiment of the invention. The filter structure 41 establishes a digital filter in transposed direct form II comprising filter coefficients b₀, b₁ and a₁. The filter structure 41 receives as input a first digital signal 103, x[n] from the ADC 30, applies then a second transfer function on the first digital signal 103 and provides a second digital signal y[n], 104 as output signal. The second transfer function is an inverse function of the first transfer function and is configured to correct the first transfer function of the analog amplifier unit 20 in the digital domain.

For the exemplary first transfer function 60 as shown in Figure 4, the inverse second transfer function may be implemented by the filter structure 41 with exemplary coefficients as follows:
b₀: 0.000955032165403
b₁: -0.000929899739998
a₁: -0.999974867575

Figure 8 shows a filter structure 42 as a possible implementation of the digital compensation unit 40 according to an embodiment of the invention. The filter structure 42 establishes a digital filter in transposed form comprising filter coefficients b₀, b₁, b₂, a₁ and a₂. The filter structure 41 receives as input a first digital signal 103, x[n]from the ADC 30, applies then a second transfer function on the first digital signal and provides a second digital signal y[n],104 as output signal. The second transfer function is an inverse function of the first transfer function and is configured to correct the first transfer function of the analog amplifier unit 20 in the digital domain.

For the exemplary first transfer function 70 as shown in Figure 5, the inverse second transfer function may be implemented by the filter structure 42 with exemplary coefficients as follows:
b₀: 0.00093937149456542
b₁: -0.00130821859676035
b₂: -0.0036916106913232
a₁: -1.98748236307729
a₂: 0.987482677044230

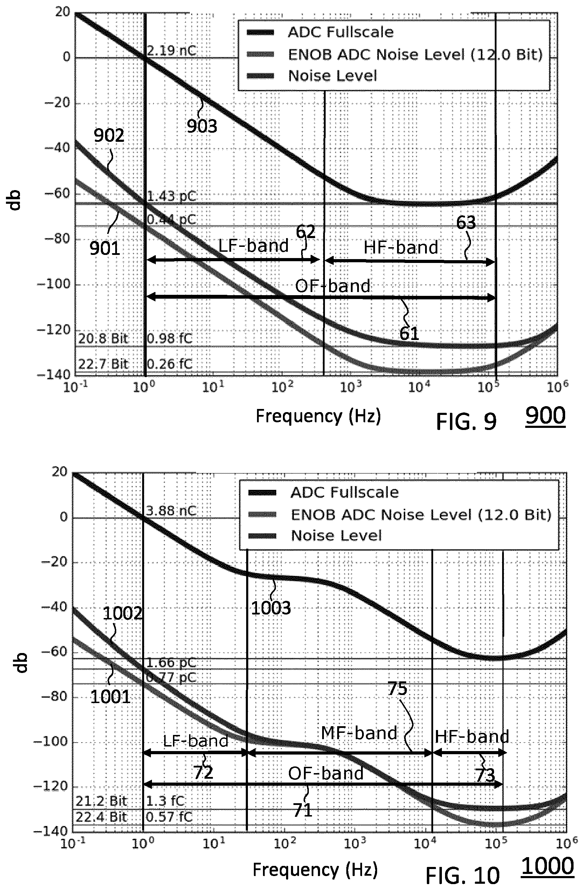

Figure 9 shows an exemplary example of measurements of the frequency dependent dynamic range of a sensor arrangement according to an embodiment of the invention. The measurements of Figure 9 correspond to the exemplary first transfer function 60 as shown in Figure 4. The x-axis denotes the frequency and the y-axis the respective signal strength in dB. More particularly, curve 901 shows the quantization noise level of the ADC 30, curve 902 the noise level of the analog amplifier output signal 102 of the amplifier unit 20 and curve 903 the maximum (fullscale) signal of the ADC 30, i.e. the largest analog amplifier output signal that the ADC 30 can reliably measure. All shown values refer to the RMS (root mean square) level of the respective signal. The dynamic range of the corresponding sensor arrangement/sensor measurement is given by the range between curve 902 and curve 903.

As can be seen, the analog amplifier output signal 902 has a noise level that is higher than the quantization noise level of the ADC over the whole operation frequency band including the low-frequency band 62 and the high- frequency band 63, in particular twice as high.

Figure 10 shows an exemplary example of measurements of the frequency dependent dynamic range of asensor arrangement according to another embodiment of theinvention. The measurements of Figure 10 correspond tothe exemplary first transfer function 70 as shown in Figure 5. The x-axis denotes the frequency and the y-axis the respective signal strength in dB. More particularly, curve 1001 shows the quantization noise level of the ADC 30, curve 1002 the noise level of the analog amplifier output signal 102 of the amplifier unit 20 and curve 1003 the maximum (fullscale) signal of the ADC 30, i.e. the largest analog amplifier output signal that the ADC 30 can reliably measure. All shown values refer to the RMS (root mean square) level of the respective signal. The dynamic range of the corresponding sensor arrangement/sensor measurement is given by the range between curve 1003 and curve 1002.

As can be seen, according to this embodiment, the analog amplifier output signal 1002 has a noise level that is higher than the quantization noise level of the ADC in the low-frequency band 72 and in the high-frequency band 73, but in the medium frequency band 75 the noise level of the analog amplifier output signal 1002 may be smaller than or equal to the quantization noise level of the ADC 30. More particularly, in the medium-frequency band, the amplitude of the vibration signal may be high while the noise level of the amplifier output signal is moderate. As a result, the analog amplification in this medium-frequency band should not be too high to avoid saturation and it may be accepted that the noise of the amplifier output signal is lower than the quantization noise level of the ADC.

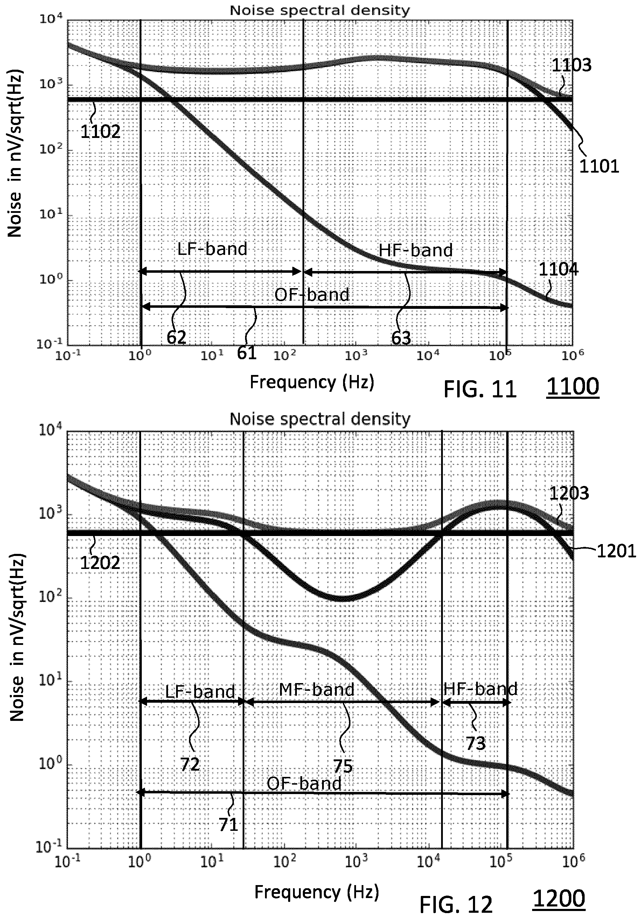

Figure 11 shows an exemplary example of measurements of the noise spectral density of the overall analog noise and the quantization noise according to an embodiment of the invention. This embodiment corresponds to the embodiment of Figures 4 and 9.

More particularly, the x-axis denotes the frequency in Hz and the y-axis the respective noise in nV/sqrt(Hz). Curve 1101 shows the total analog noise of the analog amplifier output signal 102 of the analog amplifier unit 20, curve 1102 the quantization noise level of the ADC 30, curve 1103 the total noise of the first digital signal 103 at the output of the ADC 30 and curve 1104 the overall analog and digital noise of the second digital signal 104 at the output of the digital compensation unit 40.

As can be seen, according to this embodiment, the analog amplifier output signal 102 corresponding to curve 1103 has a noise level that is higher than the quantization noise level of the ADC in the whole operation frequency band 61 including the low-frequency band 62 and the high- frequency band 63. Accordingly, the quantization noise does hardly contribute to the total noise of the first digital signal 103 and the curves 1101 and 1103 are roughly the same.

The approach as illustrated in Figures 4, 9 and 11 may be used if the dynamic range for each frequency of the operation frequency band can be covered by the resolution of the given ADC, in particular by its ENOB value.

Figure 12 shows an exemplary example of measurements of the noise spectral density of the overall analog noise and the quantization noise according to an embodiment of the invention. This embodiment corresponds to the embodiments of Figures 5 and 10.

More particularly, the x-axis denotes the frequency in Hz and the y-axis the noise in nV/sqrt(Hz). Curve 1201 shows the total analog noise of the analog amplifier output signal 102 of the amplifier unit 20, curve 1202 the quantization noise level of the ADC 30 and curve 1203 the total noise of the first digital signal 103 at the output of the ADC 30.

As can be seen, according to this embodiment, the analog amplifier output signal 102 as illustrated by curve 1201 has a noise level that is higher than the quantization noise level of the ADC 30 in the low-frequency band 72 and in the high-frequency band 73. However, in the medium frequency band 75 the noise of the analog amplifier output signal 102 (curve 1201) is smaller than the quantization noise level of the ADC 30 (curve 1202).

The approach as illustrated in Figures 5, 10 and 12 may be used if the given ADC has a lower resolution than the dynamic range of the ADC.

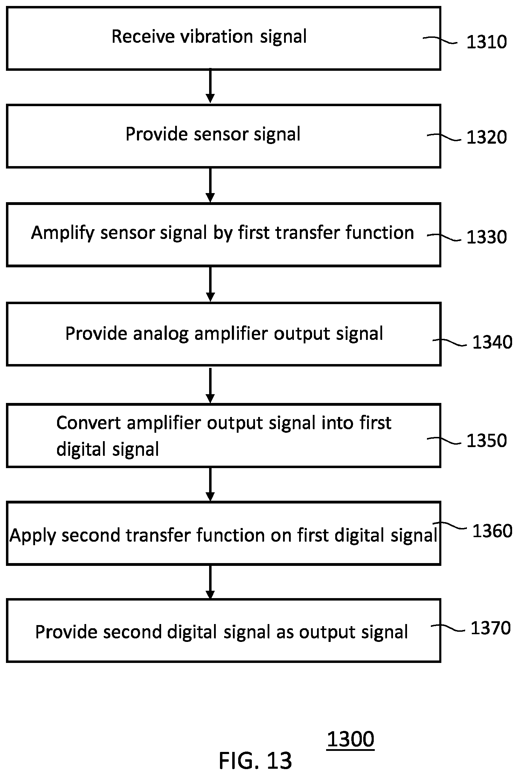

Figure 13 shows a flow chart of a method for operating a sensor arrangement according to an embodiment of the invention.

At a step 1310, a vibration sensor receives a vibration signal from a component.

At a step 1320, the vibration sensor senses the vibration signal and provides a sensor signal.

At a step 1330, an amplifier unit amplifies the sensor signal over a predefined operation frequency band with a gain according to a first transfer function.

At a step 1340, the amplifier unit provides an analog amplifier output signal.

At a step 1350, an analog-to-digital converter converts the amplifier output signal into a first digital signal.

At a step 1360, a digital compensation unit applies a second transfer function on the first digital signal. The second transfer function is an inverse function of the first transfer function.

At a step 1370, the digital compensation unit provides a second digital signal as output signal.

The block diagrams, circuit diagrams, flowcharts and further elements in the Figures illustrate the architecture, functionality, and operation of possible implementations of systems, methods, and sensor arrangements according to various embodiments of the present invention.

While there are shown and described presently preferred embodiments of the invention, it is to be distinctly understood that the invention is not limited thereto but may be otherwise variously embodied and practiced within the scope of the following claims.

## Claims

1. A sensor arrangement (100) for sensing vibrations, the sensor arrangement (100) comprising:
- a vibration sensor (10) configured to provide a sensor signal (101);
- an amplifier unit (20) configured to amplify the sensor signal (101) over a predefined operation frequency band (61, 71) with a gain according to a first transfer function (60, 70) and to provide an analog amplifier output signal (102);
- an analog-to-digital converter, ADC, (30) configured to convert the amplifier output signal (102) into a first digital signal (103); and
- a digital compensation unit (40) configured to apply a second transfer function on the first digital signal (103), wherein the second transfer function is an inverse function of the first transfer function (60, 70); wherein
- the operation frequency band (61, 71) comprises a low-frequency band (62, 72) and a high-frequency band (63, 73); and
- the gain of the predefined first transfer function (60, 70) is lower in the low-frequency band (62, 72) than in the high-frequency band (63, 73).

2. A sensor arrangement according to claim 1,
wherein the gain of the first transfer function (60, 70) increases over frequency until a predefined peak point (64, 74), wherein the predefined peak point is in the high-frequency band (63, 73).

3. A sensor arrangement according to claim 1 or claim 2,
wherein the operation frequency band (71) comprises a medium-frequency band (75) between the low-frequency band (72) and the high-frequency band (73), wherein a slope (76) of the first transfer function (70) is lower in the medium-frequency band (75) than in the low-frequency band (72) and at least in a first part (73a) of the high-frequency band (73), the first part of the high-frequency band being adjacent to the medium-frequency band.

4. A sensor arrangement according to any of the preceding claims,
wherein the vibration sensor (10) is selected from the group consisting of: a piezoelectric sensor, a piezoelectric strain sensor, a piezoelectric acceleration sensor, a MEMS acceleration sensor and a microphone.

5. A sensor arrangement according to any of the preceding claims,
wherein the operation frequency band (61, 71) has a bandwidth of more than 10 KHz, in particular more than 20 KHz; and/or
the operation frequency band has a lower limit in a range between 0.1 Hz and 10 Hz and an upper limit between 10 kHz and 1 MHz.

6. A sensor arrangement according to claim 3,
wherein
- the medium-frequency band (75) has a lower limit in a range between 5 Hz and 50 Hz and an upper limit between 200 Hz and 50 kHz.

7. A sensor arrangement according to any of the preceding claims, wherein
- the amplifier unit (20) is a charge amplifier; and
- the first transfer function (60, 70) increases over frequency with a minimum value between 10⁻⁵ V/pC and 10⁻¹ V/pC and a maximum value between 10⁻¹ V/pC and 100 V/pC.

8. A system (300) comprising
- a component (50) configured to provide a vibration signal (105);
- a sensor arrangement (100) for sensing the vibration signal (105) of the component (50), the sensor arrangement (100) comprising:
- a vibration sensor (10) configured to sense the vibration signal (105) of the component (50) and to provide a corresponding sensor signal (101) being representative for the vibrations of the component;
- an amplifier unit (20) configured to amplify the sensor signal (101) over a predefined operation frequency band (61, 71) with a gain according to a first transfer function (60, 70) and to provide an analog amplifier output signal (102);
- an analog-to-digital converter, ADC, (30) configured to convert the amplifier output signal (102) into a first digital signal (103); and
- a digital compensation unit (40) configured to apply a second transfer function on the first digital signal (103), wherein
- the second transfer function is an inverse function of the first transfer function (60, 70);
- the vibration signal (105) has higher amplitudes in a low-frequency band (62, 72) of the operation frequency band than in a high-frequency band (63, 73) of the operation frequency band;
- the vibration signal (105) has a higher noise level in the low-frequency band (62, 72) than in the high-frequency band (63, 73); and
- the amplifier unit (20) is configured to provide the analog amplifier output signal with a noise level that is higher than a quantization noise level of the ADC (30), in particular twice as high as the quantization noise level of the ADC, at least in the low-frequency band (62, 72) and in the high-frequency band (63, 73).

9. A system according to claim 8, wherein the component (50) is selected from the group consisting of: a machine, a tool, a production site, an infrastructure, an engine, a pump, a turbine, a bearing, a housing, a container, a building, a gear, a transportation means, a vehicle, a heater, a burner and a boiler.

10. Use of a sensor arrangement (100) according to any of the preceding claims 1 to 7 for one or more of:
- measuring vibrations of a component (50), preferably of a component of or a component coupled to one of a machine, a tool, a production site, an infrastructure, an engine, a pump, a turbine, a bearing, a housing, a container, a building, a gear, a transportation means and a vehicle,
- monitoring a condition and / or a quality of a component, or the condition and / or a quality of a machine, a tool, a production site, infrastructure, an engine, a pump, a turbine, a bearing, a housing, a container, a building, a gear, a transportation means or a vehicle the component is comprised in or is coupled to,
- predicting maintenance operations of a component or of a machine, a tool, a production site, infrastructure, an engine, a pump, a turbine, a bearing, a housing, a container, a building, a gear, a transportation means or a vehicle the component is comprised in or is coupled to,
- measuring structure borne sound and / or noise, in particular measuring road noise and / or monitoring the condition and / or quality of a road based on the measured noise, by mounting the strain sensor on a vehicle, in particular measuring a status of one of a heater, a burner and a boiler, in particular measuring structure borne sound and / or noise on a living being, preferably on a human being, by way of coupling the strain sensor to a living being, preferably implementing a hearing aid and / or noise cancellation for the living being.

11. A method for operating a sensor arrangement (100) according to any of the preceding claims 1 to 7, comprising
- receiving, by a vibration sensor (10), a vibration signal (105);
- providing, by the vibration sensor (10), a sensor signal (101);
- amplifying, by an amplifier unit (20), the sensor signal (101) over a predefined operation frequency band (61, 71) with a gain according to a first transfer function (60, 70);
- providing, by the amplifier unit (20), an analog amplifier output signal (102);
- converting, by an analog-to-digital converter, ADC, (30) the amplifier output signal (102) into a first digital signal (103); and
- applying, by a digital compensation unit (40), a second transfer function on the first digital signal (103), wherein the second transfer function is an inverse function of the first transfer function; wherein
- the operation frequency band (61, 71) comprises a low-frequency band (62, 72) and a high-frequency band (63, 73); and
- the gain of the predefined first transfer function (60, 70) is lower in the low-frequency band (62, 72) than in the high-frequency band (63, 73).

12. A method according to claim 11, wherein the vibration signal (105) has
- higher amplitudes in the low-frequency band (62, 72) than in the high-frequency band (63, 73); and
- a higher noise level in the low-frequency band (62, 72) than in the high frequency-band (63, 73).

13. A method according to claim 11 or claim 12, wherein
- the analog amplifier output signal (102) has a noise level that is higher than a quantization noise level of the ADC (30), in particular twice as high as the quantization noise level of the ADC, at least in the low-frequency band (62, 72) and in the high-frequency band (63, 73).

14. A method according to any of the preceding claims 11-13, wherein
- the analog amplifier output signal (102) has a noise level that is higher than the quantization noise level of the ADC, in particular twice as high as the quantization noise level of the ADC, in the whole operation frequency band (61).

15. A method according to any of the preceding claims 11-14, wherein the digital compensation unit (40) provides a second digital signal (104) as output signal, wherein the second digital signal (104) provides a higher digital resolution of the vibration signal (105) than the effective number of bits of the ADC (30).
